(19) Europäisches Patentamt / European Patent Office / Office européen des brevets

(11) **EP 1 726 034 B1**

(12) **EUROPÄISCHE PATENTSCHRIFT**

(45) Veröffentlichungstag und Bekanntmachung des Hinweises auf die Patenterteilung:
**14.10.2009 Patentblatt 2009/42**

(21) Anmeldenummer: **05715818.0**

(22) Anmeldetag: **08.03.2005**

(51) Int Cl.:
**H01L 21/00** (2006.01)

(86) Internationale Anmeldenummer:
**PCT/EP2005/002413**

(87) Internationale Veröffentlichungsnummer:
**WO 2005/088680 (22.09.2005 Gazette 2005/38)**

(54) **VERFAHREN ZUR FÖRDERUNG VON SILICIUMFESTSTOFFPARTIKELN**

PROCESS FOR CONVEYING SILICON SOLIDS PARTICLES

PROCEDE POUR TRANSPORTER DES PARTICULES SOLIDES DE SILICIUM

(84) Benannte Vertragsstaaten:
**AT BE BG CH CY CZ DE DK EE ES FI FR GB GR HU IE IS IT LI LT LU MC NL PL PT RO SE SI SK TR**

(30) Priorität: **09.03.2004 EP 04005539**

(43) Veröffentlichungstag der Anmeldung:
**29.11.2006 Patentblatt 2006/48**

(73) Patentinhaber: **SCHOTT Solar AG**
**55122 Mainz (DE)**

(72) Erfinder:
• **SCHWIRTLICH, Ingo**
**63987 Miltenberg (DE)**
• **VON CAMPE, Hilmar**
**61352 Bad Homburg (DE)**

(74) Vertreter: **Stoffregen, Hans-Herbert**
**Patentanwalt**
**Friedrich-Ebert-Anlage 11b**
**63450 Hanau (DE)**

(56) Entgegenhaltungen:
**WO-A-86/06764      WO-A-87/01362**
**WO-A-90/14450      WO-A-91/05723**
**GB-A- 1 406 650     US-A- 3 168 350**
**US-A- 4 130 071     US-A- 5 242 531**
**US-A- 6 090 199**

EP 1 726 034 B1

**Beschreibung**

Die Erfindung bezieht sich auf ein Verfahren zum Fördern von Silicium-Feststoffpartikeln unregelmäßiger Geometrie zu einer Siliciumschmelze, aus der durch Kristallisation festes Silicium hergestellt wird.

In der Halbleitertechnik werden Siliciumeinkristalle für mikromechanische Bauelemente als Substrat oder für Solarzellen verwendet. Zur Herstellung der Siliciumeinkristalle gelangt vorwiegend das Czochralski-Verfahren oder die Float Zone-Technik zur Anwendung. Gelegentlich wird auch das vertikale Bridgeman-Verfah.ren oder Züchtungstechniken aus einer metallischen Lösung wie in der Flüssigphasenepitaxie verwendet.

In der Solarzellenfertigung wird Silicium in Form dicker Blöcke mit verschiedenen Block-Kristallisations-Verfahren hergestellt. Dabei entstehen durch einfaches Abkühlen oder durch gerichtetes Erstarren der Schmelze grobkristalline Silicium-Blöcke mit Korngrößen im Bereich von 1 mm bis zu einigen Zentimetern.

Auch ist es bekannt, Silicium aus schmelzflüssiger Phase direkt in Form einer Scheibe mit definiert eingestellter Dicke kristallisieren zu lassen. Bei diesem Verfahren handelt es sich um sogenannte Bandziehverfahren, zu denen das "Edge-Defined Film-fed Growth" der RWE Schott Solar GmbH, das lineare Bandziehverfahren "Continous String Ribbon Growth" von Evergreen Solar Inc. sowie das "Ribbon Growth on Substrates"-Verfahren der Bayer AG gehören.

Bei Bandziehverfahren ist die Befüllung von sogenannten Kristallzüchtungstiegeln mit Ausgangsmaterial von Wichtigkeit, um aus der in dem Tiegel vorhandenen Siliciumschmelze die Siliciumscheiben reproduzierbar ziehen zu können. Bei Anlagen herkömmlicher Bauart werden entsprechende Kristallzüchtungstiegel mit mehrere Zentimeter großen Granulatkörnern, dem sogenannten PolySilicium von Hand befüllt. Dieses PolySilicium weist einen hohen Reinheitsgrad auf. Bei Wiederverwendung von Silicium, das eine geringere Reinheit aufweist und vor allem wegen des niedrigen Materialpreises zur Herstellung von Solarzellen eingesetzt wird, werden Bruchstücke wie rezyklierte Wafer, fehlerhafte Kristalle oder Sägeabschnitte wie Tops und Tails sowie Seiten- und Randstücke von nach dem Czochralski-Verfahren oder Float-Zone-Technik-Verfahren hergestellten Kristallen oder Abschnitte von Blockgussmaterial, fehlerhafte PolySiliciumstäbe oder ähnliches auf diese Weise wieder verwendet.

Durchlaufverfahren, bei denen kristallines Ausgangsmaterial in fester oder flüssiger Form dem Schmelztiegel zugeführt wird, während die Kristallzüchtung erfolgt, sind vor allem beim Czochralski-Verfahren und beim Edge-Defined Film-fed Growth-Verfahren bekannt. Allerdings erfordert gerade bei letzterem Verfahren die kontinuierliche Zuführung kleinerer Kristallpartikel von der Größenordnung einiger Millimeter, die während des Kristallisationsvorganges in dem Umfang der Schmelze zugeführt werden müssen, wie Material durch den wachsenden Kristall aus der Schmelze entfernt wird.

Nach dem Stand der Technik werden sphärische Siliciumpartikel benutzt, die bei hohen Temperaturen aus einem Wirbelbett mittels Gasphasenabscheiden von Silan bei einer Temperatur zwischen 600 °C und 900 °C oder von Trichlorsilan bei einer Temperatur von 1000 °C bis 1300 °C in reduzierendem Wasserstoff abgeschieden werden. In größerem Maßstab lieferbar sind zur Zeit die aus Silan abgeschiedenen Partikel. Wegen der hohen Reinheitsanforderungen von Seiten der Halbleiterindustrie sind diese jedoch sehr teuer.

Bei der kontinuierlichen Nachbefüllung der Kristallzüchtungstiegel ist der Nachteil gegeben, dass auf Grund der erforderlichen thermischen Abschirmung der Zugang zum Kristallzüchtungstiegel - der auch als Schmelztiegel bezeichnet werden kann - erschwert ist. Somit sind spezielle Transporttechniken in einem speziellen Rohrsystem erforderlich. Dabei werden nach dem Stand der Technik sphärische Partikel definierter Größe über Rinnen oder durch die Schwerkraft mittels eines Gasstroms in einem Rohr dem Tiegel zugeführt.

Der US-A-4,016,894 ist ein Verfahren zur Reduzierung des Druckverlustes einer strömenden Flüssigkeit zu entnehmen, indem eine Mischung aus hygroskopischem und hydrophobischem Pulver zugefügt wird. Als Material kommt eine Mischung aus Siliziumdioxid und Polyethylenoxid oder Siliziumdioxid und Polyacrylamid in Frage.

Aus der US-A-5,683,503 ist ein Verfahren zum Fördern von Betonschlamm bekannt, wobei zur Verbesserung der Förderung Zusätze beigegeben werden. Hierbei kann es sich um Natriumcarbonat, Polyethylenoxid, Hydroxidethylcellulose oder Carboxymethylcellulose handeln.

Die EP-A 1 245 703 bezieht sich auf ein Verfahren zur Herstellung eines Komposit-Werkstoffs mit einer $SiO_2$-haltigen Matrix, in der eine Quarzglaskörnung eingebettet ist.

Aus der GB-A-1 406 650 ist ein Verfahren bekannt, bei dem Polyethylenfasem mit Polyethylenklumpen mittels Gas transportiert werden.

Die WO-A-87/01362 beschreibt ein Verfahren, bei dem Grobkohle vermischt mit Staubpartikeln, wie Staubkohle, mit Hilfe von flüssigem Kohlendioxid transportiert wird.

Nach der WO-A-90/14450 werden von einem Vorratsbehälter Siliciumpartikel in eine Aufnahme schwerkraftbedingt zugeführt, von dem mittels eines Gasstroms über ein vertikal verlaufendes Rohr ein weiterer Transport in eine Siliciumschmelze erfolgt. Die Siliciumpartikel weisen eine Kugelform auf und haben in etwa gleiche Masse und gleiches Volumen. Eine prinzipiell gleiche Verfahrensweise ergibt sich aus der WO-A-91/05723.

Zum Ziehen eines Siliciumeinkristalls wird nach der WO-A-86/06764 vorgeschlagen, dass einer Schmelze, aus der der Einkristall gezogen wird, Siliciumkugeln aus zumindest zwei Vorratsbehältern zugeführt werden, wobei die Siliciumpartikel in den einzelnen Vorratsbehältern unterschiedlich dotiert sind.

Nach dem Czochralski-Verfahren werden nach der US-A-5,242,531 Siliciumkristalle gezogen, wobei Siliciumausgangsmaterial schwerkraftbedingt einer Schmelze zugeführt wird.

Zum Ziehen von Kristallen aus Halbleitermaterialien wird nach der US-A-6,090,199 einer Schmelze über ein Förderband Granulat zugeführt, das zuvor auf das Förderband über einen Trichter abgegeben wird.

Der vorliegenden Erfindung liegt das Problem zu Grunde, ein Verfahren der eingangs genanten Art so weiterzubilden, dass wohl dosiert im gewünschten Umfang auch Bruchstücke oder sonstige eine unregelmäßige Geometrie aufweisende Feststoffpartikel zu einer Siliciumschmelze gefördert werden können, ohne dass die Gefahr erwächst, dass die Partikel in dem die Partikel führenden Rohr bzw. Rohrsystem hängen bleiben und somit zu Verstopfungen führen können.

Zur Lösung des Problems wird vorgeschlagen ein Verfahren zum Fördern von Silicium-Feststoffpartikeln unregelmäßiger Geometrie zu einer Siliciumschmelze, aus der durch Kristallisation festes Silicium hergestellt wird, wobei den Silicium-Feststoffpartikeln unregelmäßiger Geometrie wie gebrochenes Siliciummaterial als erste Feststoffpartikel zum Fördern mittels eines Fluides durch zumindest ein eine Kurve oder mehrere Kurven und/oder einen Knick oder mehrere Knicke aufweisendes Rohr oder Rohrsystem aus Silicium bestehende oder dieses enthaltende zweite Feststoffpartikel regelmäßiger Geometrie, wie sphärischer oder ellipsoider Geometrie, zugegeben werden.

Erfindungsgemäß werden zum Fördern der Feststoffpartikel unregelmäßiger Geometrie als Trägermedium neben dem Förderfluid, das ein Gas ist, zweite Feststoffpartikel zugegeben, die eine regelmäßige wie Kugel- oder Ellipsoidgeometrie aufweisen. Diese bewirken eine verbesserte Fließfähigkeit der ersten Feststoffpartikel, so dass in Folge dessen sichergestellt ist, dass im erforderlichen Umfang und dosiert z. B. Siliciumpartikel einer Schmelze zugeführt werden können. Somit eröffnet sich z. B. die Möglichkeit, zerkleinertes Material von kostengünstigen Siliciumpartikeln wie Kristall-Bruchstücken, rezyklierten gebrochenen Wafern, gebrochenen fehlerhaften Kristallen oder Sägeabschnitten, um nur einige Beispiele zu nennen, zu verwenden, die geschmolzen werden.

Die erfindungsgemäße Lehre bietet ein Trockenförderverfahren für Partikel wie gebrochenes Granulat beliebiger Form mit einer breiten Korngrößenverteilung. Dabei besteht die Möglichkeit, ein Knicke und Bögen aufweisendes Rohrsystem zu verwenden, ohne dass die Gefahr eines Verstopfens erwächst. Es werden folglich im Fall der Kristallzüchtung regelmäßig geformte sphärische Siliciumpartikel mit unregelmäßig geformten Bruchstücken aus Silicium in einen Tiegel gefördert. Unter unregelmäßig geformte Bruchstücke können dabei Granulate, Körner oder scheibchenförmige Teilchen aus gebrochenem Siliciummaterial subsumiert werden. Als Ausgangsprodukte sind CVD-Poly-Siliciumstäbe, Bruchstücke von multikristallinen Blöcken, Bruch- und Endstücke von Siliciumeinkristallen sowie Bruchstücke von mono- oder multikristallinen Wafern zu nennen.

Förderrate und Gleichmäßigkeit der Förderung hängt von den Anteilen zwischen großen und kleinen Partikeln ab. Dabei nimmt die Förderrate mit zunehmendem Anteil an unregelmäßig geformtem Material ab. Besonders gute Förderergebnisse lassen sich dann erzielen, wenn der Anteil der ersten Feststoffe als die Partikel, die eine unregelmäßige Außengeometrie aufweisen, in etwa 1 % bis in etwa 50 % von der Gesamtmenge der ersten und zweiten Feststoffpartikel beträgt.

Die ersten Partikel sollten des Weiteren eine Korngröße zwischen 0,3 mm bis 5 mm, vorzugsweise im Bereich zwischen 0,5 mm und 3,0 mm aufweisen.

Um den Einfluss von Ecken und Kanten im Rohrsystem zu minimieren, sollte das Längen- und Breitenverhältnis des Granulates < 3 betragen. Unabhängig hiervon wird die Fließfähigkeit mit der Zunahme des Anteils an den zweiten, also sphärischen Partikeln erhöht.

Ursächlich für die Verringerung der Förderrate bei einem Längen-Breitenverhältnis > 3 für die ersten Feststoffpartikel dürfte sein, dass in diesem Falle Granulatkörner verhaken können und somit das Rohr bzw. Rohrsystern, durch das die Partikel gefördert werden, verstopfen kann. Werden jedoch entsprechende längliche Körper mit einem Längen-Breitenverhältnis < 3 mit kleinerem fließfähigen Material, also den zweiten eine sphärische Geometrie aufweisenden Partikeln gleichmäßig vermischt, so verbessert sich die Förderrate, da in diesem Fall die ersten Feststoffpartikel quasi von den zweiten Feststoffpartikeln umgeben und mittels dieser gefördert werden.

Des Weiteren sieht die Erfindung vor, dass die ersten Feststoffpartikel eine maximale Länge L aufweisen, die gleich oder kleiner als Radius des Rohres bzw. Rohrsystems ist, durch das die Partikel gefördert werden.

Eine Verbesserung der Förderfähigkeit ergibt sich dann, wenn gezielt Fluidpakete, also Gaspakete zur Förderung zugegeben werden, wodurch die Partikel durch das Fluid auf gelockert werden. Die geförderten Ansammlungen von Feststoffpartikeln erfahren hierdurch eine Änderung ihrer relativen Anordnung zueinander, so dass Hindernisse wie Bögen, Ecken oder Kanten bzw. raue und unebene Oberflächen des Rohres bzw. Rohrsystems besser überwunden werden können. Somit wird die Fließfähigkeit des Materials erhöht. Daher sieht eine Weiterbildung der Erfindung vor, dass das Fluid dem Rohr gepulst zugeführt wird. Auch besteht die Möglichkeit, dass die Feststoffpartikel in Abschnitten des Rohrsystems beschleunigt werden. Unabhängig davon ist bevorzugterweise vorgesehen, dass als Fluid ein Gas bestehend aus Pressluft, Stickstoff, Argon und/oder Kohlendioxid oder eine Mischung dieser verwendet wird.

Eine weitere hervorzuhebende Ausgestaltung der Erfindung sieht vor, dass die in die Siliciumschmelze zugeführten Feststoffpartikel zur Dotierung der Schmelze dienen. Mit anderen Worten wird die Siliciumschmelze mittels insbesondere in den ersten Feststoffpartikeln vorhandener Dotierelemente dotiert. Hierzu können hochdotierte Siliciumkörner aus dotierten Reststücken durch Zerkleinerung hergestellt und entsprechend der gewünschten Dotierung in den zu ziehenden Kristallen anteilig im Verhältnis unter undotierte Feststoffpartikel gemischt werden, die vorzugsweise sphärische Geometrie, also Kugelgeometrie aufweisen.

Als Dotierstoffe können bor- und/oder phosphordotierte Materialien eingesetzt werden. Aber auch andere Elemente der III. Gruppe des Periodensystems wie Al, Ga, In und/oder der V. Gruppe des Periodensystems wie As, Sb können verwendet werden.

Eine Dotierung der Schmelze erfolgt zum Beispiel, indem man dem undotierten Material aus ersten unregelmäßig geformten Teilchen und zweiten sphärischen Teilchen hochdotierte Bruchstücke der Größe 0,3-10 mm, vorzugsweise 0,5 - 3,0 mm eines Kristalls zugibt. Dieses geschieht, indem man z. B. einen hochdotierten Kristall mit einer Dotierung $p_1$ zerkleinert und die Bruchstücke entsprechend der gewünschten Dotierung der Schmelze anteilig zumischt.

Alternativ kann man dotiertes Material einer Dotierung $p_i$ aus ersten unregelmäßig geformten Teilchen und zweiten sphärischen Teilchen ebenfalls verwerten, indem man es mit undotiertem Material so mischt, dass sich eine resultierende Dotierung $p_r$ ergibt gemäß der Beziehung:

$$m_1 p_1 + m_2 p_2 + \ldots + m_n p_n = (m_1 + m_2 + \ldots + m_n) p_r \quad ,$$

wobei die $m_i$ die einzelnen Massen der Si-Anteile mit der jeweiligen Dotierung $p_i$ sind.

Die Erfindung zeichnet sich auch dadurch aus, dass hochdotierte erste Feststoffpartikel der Dotierung $p^+_1$, $p^+_2$, ..., $p^+_n$ der Dotierungskonzentration $p^+_i$ mit $1 \times 10^{17}$ cm$^{-3} \leq p^+_i \leq 1 \times 10^{20}$ cm$^{-3}$, insbesondere mit $p^+_i$ : $1 \times 10^{18}$ cm$^{-3} \leq p^+_i \leq 1 \times 10^{19}$ cm$^{-3}$, in den Mengen $m^+_1$ bis $m^+_n$ zusammen mit zweiten weniger dotierten Feststoffpartikeln der Konzentrationen $p_1$, $p_2$, ..., $p_m$ der Dotierungskonzentration $p_j$ mit $1 \times 10^{13}$ cm$^{-3} \leq P_j \leq 1 \times 10^{17}$ cm$^{-3}$, insbesondere mit $p_j$ : $1 \times 10^{14}$ cm$^{-3} \leq p_j \leq 1 \times 10^{16}$ cm$^{-3}$, in den Mengen $m_1$ bis $m_m$ so vermischt werden, dass sich eine resultierende Dotierung der Schmelze $p_r$ ergibt, wobei die Beziehung gilt:

$$\sum_{i=1}^{n} m^+_i p^+_i + \sum_{j=1}^{m} m_j p_j = p_r \left( \sum_{i=1}^{n} m_i + \sum_{j=1}^{m} m_j \right) \quad .$$

Insbesondere zeichnet sich die Erfindung durch ein kontinuierliches Verfahren zur Herstellung von festem Silicium durch Kristallisation des Siliciums aus einer Siliciumschmelze, insbesondere zur Herstellung von Siliciumscheiben nach dem Edge-Defined Film-fed Growth (EFG)-Verfahren, wobei aus einem Behältnis kristallines Silicium in Form eines Feststoffes der Schmelze zugeführt wird, dadurch aus, dass der Feststoff aus ersten und zweiten Feststoffpartikeln besteht oder diese zumindest enthält, dass die ersten Feststoffpartikel aus gebrochenem Silicium bestehen und die zweiten Siliciumpartikel eine sphärische Geometrie aufweisen, und dass der Feststoff mittels eines Fluids wie Gases gefördert wird. Dabei wird das Feststoffmaterial durch ein Rohr gefördert, das die Schmelze mittig durchsetzt oder von dieser konzentrisch umgeben ist. Die Feststoffpartikel werden über ein oberhalb des Rohres angeordnetes eine Kegelgeometrie aufweisendes Umlenkelements in Richtung des Behälters umgelenkt. Ferner werden die Feststoffpartikel über ein das Rohr umgebendes außenrandseitig im Bereich der Schmelze verlaufendes eine Kugeloberflächenabschnittgeometrie aufweisendes Abweiselement in die Schmelze geleitet.

Weitere Einzelheiten, Vorteile und Merkmale der Erfindung ergeben sich nicht nur aus den Ansprüchen, den diesen zu entnehmenden Merkmalen - für sich und/oder in Kombination -, sondern auch aus der nachfolgenden Beschreibung von der Zeichnung zu entnehmendem bevorzugten Ausführungsbeispiel.

Es zeigen:

Fig. 1    eine Prinzipdarstellung einer Anordnung zum Zuführen von Siliciumpartikeln in eine Schmelze und

Fig. 2    ein Diagramm einer partikelabhängigen Förderrate.

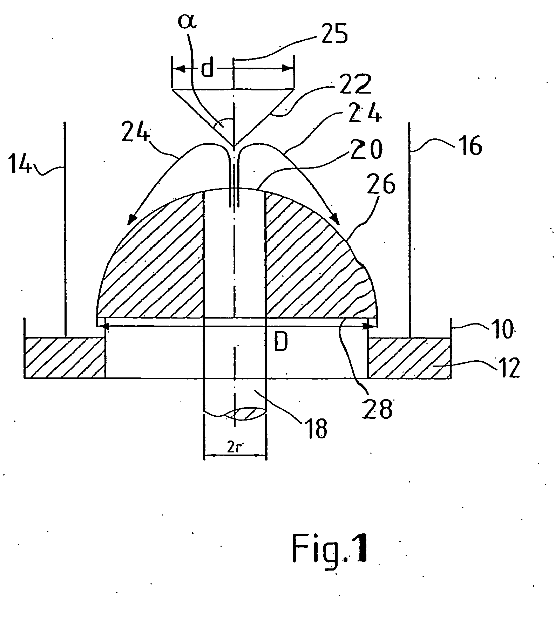

In Fig. 1 ist rein prinzipiell eine Anordnung dargestellt, mittels der aus Silicium bestehende oder Silicium enthaltende Feststoffpartikel einer in einem als Rinne 10 ausgebildeten Schmelztiegel vorhandenen Siliciumschmelze 12 zugeführt werden.

Aus der Rinne 10 bzw. der Siliciumschmelze 12 wird nach dem Edge-Defined Film-fed Growth (EFG)-Bandziehverfahren ein Hohlkörper aus kristallisiertem Silicium gezogen. Abschnitte, also scheibenförmige Flächenanteile des Hohlkörpers sind mit den Bezugszeichen 14 und 16 gekennzeichnet. Um in Abhängigkeit von der Menge des aus der Schmelze 12 kristallisierten Silicium Siliciumpartikel wohl dosiert zuzuführen, ist ein einen Rohrabschnitt 18 umfassendes Rohrsystem vorgesehen, durch das die Siliciumpartikel insbesondere mittels eines Gasfluides gefördert werden. Das Rohr 18 verläuft entlang der gedachten Symmetrielinie 25 der Rinne 10. Oberhalb des Rohres 18 bzw. dessen Öffnung 20 ist ein Umlenkelement 22 angeordnet, das die Geometrie eines auf den Kopf gestellten Kegels aufweist. Aus dem Rohr 18 beförderte Partikel werden demzufolge bei Auftreffen auf das Umlenkelement 22 umgelenkt (Pfeile 24), um sodann über ein Abweiselement 26 der Schmelze 12 zugeführt zu werden. Das Abweiselement 26 umgibt konzentrisch das Rohr 18 und weist eine Kegeloberflächenabschnittsgeometrie, also quasi eine Schirmgeometrie auf, deren peripherer Rand 28 oberhalb der Schmelze 12 endet. Hierdurch ist sichergestellt, dass die entlang der Oberfläche des Abweiselementes 26 geführten Siliciumpartikel gezielt in die Schmelze 12 gelangen, ohne dass die Gefahr besteht, dass ein Auftreffen auf den Hohlkörper aus kristallisiertem Silicium erfolgt.

Das Umlenkelement 22 sollte insbesondere eine auf die Spitze gestellte Kreiskegelform aufweisen, wobei der Winkel $\alpha$ zwischen Seitenflächen und Mittelachse $30° \leq \alpha \leq 60°$, insbesondere $\alpha \approx 45°$ beträgt.

Der Durchmesser in der Basisfläche des Umlenkelements 22 beläuft sich auf d. Demgegenüber weist das Abweiselement 26 an der Basis einen Durchmesser D auf. Zwischen den Durchmessern d und D sollte die geometrische Beziehung $0,2 \leq d/D < 0,8$ gelten.

Das Siliciummaterial besteht aus ersten und zweiten Siliciumpartikeln, von denen erste Partikel eine unregelmäßige Geometrie und zweite Partikel eine sphärische Geometrie aufweisen. Durch die Mischung der ersten und zweiten Siliciumpartikel ist sichergestellt, dass ein problemloses Fördern der eine unregelmäßige Geometrie aufweisenden ersten Partikel durch das Bögen rund gegebenenfalls Abwinkelungen aufweisende Rohrsystem erfolgt, ohne dass die Gefahr eines Verhakens der Partikel untereinander oder eines Ablagerns in dem Rohr erfolgt. Dies bewirken die zweiten Siliciumpartikel, die quasi als Trägersubstanz für die ersten Siliciumpartikel dienen. Als erste Siliciumpartikel kommt insbesondere gebrochenes Siliciummaterial in Frage. So können als Ausgangsstücke CVD-Poly-Siliciumstäbe, Bruchstücke von multikristallinen Blöcken, Bruch- und Endstücke von Siliciumeinkristallen sowie Bruchstücke von mono- und multikristallinen Wafern verwendet werden. Hierdurch bedingt kann relativ kostengünstiges Siliciumausgangsmaterial benutzt werden, um den Siliciumhohlkörper zu ziehen.

Ferner ergibt sich der Vorteil, dass die eine unregelmäßige Oberflächengeometrie aufweisenden ersten Siliciumpartikel aus dotierten Reststücken bestehen können, wodurch eine gezielte Dotierung der Schmelze 12 erfolgen kann. Als Dotierstoffe kommen Bor und Phosphor aber auch Element der III. Gruppe des Periodensystems wie Al, Ga, In oder der V. Gruppe des Periodensystems wie As und Sb in Frage. Insbesondere ist durch gezieltes mengenmäßiges Vermischten der ersten die Dotierstoffe enthaltenden Partikel mit den zweiten Partikeln die Möglichkeit gegeben, die Dotierkonzentration in der Schmelze 12 auf $1 \cdot 10^{17}$ cm$^{-3}$ bis $1 \cdot 10^{20}$ cm$^{-3}$, vorzugsweise im Bereich von $1 \cdot 10^{18}$ cm$^{-3}$ bis $1 \cdot 10^{19}$ cm$^{-3}$ kostengünstig einzustellen.

Um die Förderfähigkeit zu erhöhen, kann als Förderfluid ein insbesondere gepulstes Gas benutzt werden, das durch das Rohrsystem geschickt wird. Auch kann über Anschlüsse in dem Rohrsystem oder Veränderungen des Rohrquerschnitts ein abschnittsweises Beschleunigen der Partikel erfolgen, wodurch eine zusätzliche Vermischung der Partikel untereinander erfolgt und somit die Fließfähigkeit verbessert werden kann.

Die Siliciumpartikel unregelmäßiger Geometrie sollten ein maximales Längen- zu Breitenverhältnis < 3 aufweisen. Des Weiteren sollte die maximale Länge kleiner als der Radius des Rohres 18 bzw. minimaler Radius eines in dem Rohrsystem vorhandenen Abschnitts sein.

Des Weiteren ist vorgesehen, dass die Temperatur des Abweisers 26 bzw. Umlenkelementes 22 im Bereich zwischen 300 °C und 1200 °C, bevorzugterweise zwischen 1000 °C und 1120 °C liegt. Durch diese Maßnahmen wird sichergestellt, dass die Schmelze 12 beim Eintauchen der Partikel eine Temperaturänderung nicht in einem Umfang erfährt, der die Güte des zu ziehenden Hohlkörpers 14, 16 beeinflusst.

Auch sollten das eine Kegelgeometrie aufweisende Umlenkelement 22 und das Abweiselement 26 in ihrer Geometrie auf die Morphologie und das Mischungsverhältnis der Feststoffpartikel abgestimmt sein.

Zur Erläuterung ist zu sagen, dass der Kegelwinkel des Umlenkelementes zwischen 30° und 45° liegen sollte, wenn die unregelmäßige Teilchen (lange Nadeln mit Länge zu Breite ≈ 3) in hohem Mischungsverhältnis vorkommen, damit die Teilchen möglichst horizontal reflektiert werden und auf der Flugparabel möglichst weit über das Abweiselement geschleudert werden.

Der Winkel des Abweiselementes soll größer als 35° sein, vorzugsweise 40°, wenn die Zahl der unregelmäßigen Teilchen mehr als 10% beträgt, da die unregelmäßigen Teilchen bei Winkeln > 40° problemlos abrutschen. Beträgt der Winkel < 30° - 40 ° neigt das Material zum Liegenbleiben.

Längliche Partikel mit einer Breite B und einer Länge L sollten derart dimensioniert sein, dass die Länge $L \leq 3B$ ist. Ferner sollte der Krümmungsradius des Rohres, in dem die Partikel transportiert werden, mindestens sechsfacher Breite B entsprechen.

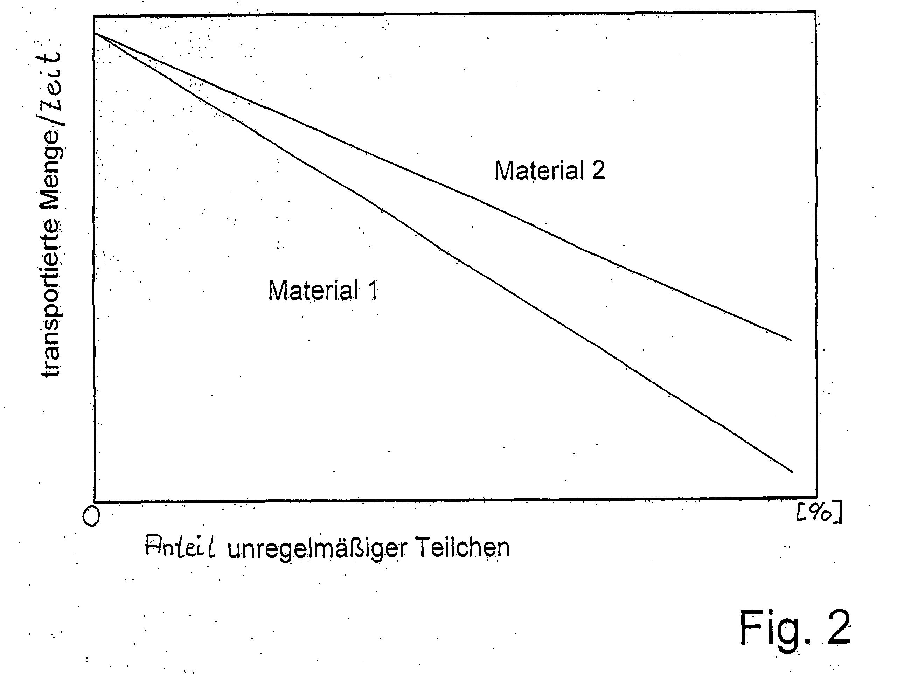

Die Förderrate der der Schmelze 12 zuzuführenden Siliciumpartikel hängt von dem Mengenverhältnis zwischen ersten und zweiten Siliciumpartikeln ab. Dies wird an Hand der Fig. 2 verdeutlicht. In dieser ist transportierte Menge im Verhältnis unregelmäßiger Teilchen zu kugelförmigen Teilchen dargestellt. Dabei weist das Material 1 unregelmäßigere erste Teilchen als das Material 2 auf. Sind keine unregelmäßigen Feststoffpartikel in der zu fördernden Mischung enthalten, so ist die pro Einheit transportierte Menge gleich. Mit zunehmendem Anteil von Feststoffpartikeln unregelmäßiger Geometrie nimmt die transportierte Menge pro Zeiteinheit ab, wobei die Mischung, die unregelmäßigere Feststoffpartikel enthält, einen stärkeren Abfall zeigt.

## Patentansprüche

1.  Verfahren zum Fördern von Silicium-Feststoffpartikeln unregelmäßiger Geometrie zu einer Siliciumschmelze, aus der durch Kristallisation festes Silicium hergestellt wird, wobei den Silicium-Feststoffpartikeln unregelmäßiger Geometrie wie gebrochenes Siliciummaterial als erste Feststoffpartikel zum Fördern mittels eines Fluides durch zumindest ein eine Kurve oder mehrere Kurven und/oder einen Knick oder mehrere Knicke aufweisendes Rohr oder Rohrsystem aus Silicium bestehende oder dieses enthaltende zweite Feststoffpartikel regelmäßiger Geometrie, wie sphärischer oder ellipsoider Geometrie, zugegeben werden.

2.  Verfahren nach Anspruch 1,
    **dadurch gekennzeichnet,**
    **dass** der Anteil der ersten Feststoffpartikel in etwa 1 % bis in etwa 50 % von Gesamtmenge der ersten und zweiten Feststoffpartikel beträgt.

3.  Verfahren nach Anspruch 1,
    **dadurch gekennzeichnet,**
    **dass** die Feststoffpartikel mittels Fluidpaketen gefördert werden, wobei insbesondere das Fluid in regelmäßigen oder unregelmäßigen Zeitabständen gepulst dem Rohr bzw. Rohrsystem zugeführt wird.

4.  Verfahren nach Anspruch 1,
    **dadurch gekennzeichnet,**
    **dass** die ersten Feststoffpartikel eine längliche Form mit einer Breite B und einer Länge L mit einem Längen- zu Breitenverhältnis von L : B in etwa $\leq$ 3 aufweisen.

5.  Verfahren nach zumindest Anspruch 4,
    **dadurch gekennzeichnet,**
    **dass** die Länge L der ersten Feststoffpartikel maximal Radius des Rohres ist.

6.  Verfahren nach Anspruch 1,
    **dadurch gekennzeichnet,**
    **dass** als gebrochenes Siliciummaterial Bruchstücke von CVD-Poly-Siliciumstäbe, Bruchstücke von multikristallinen Blöcken, Bruch- und/oder Endstücke von Siliciumeinkristallen, Bruchstücke von mono- und/oder multikristallinen Wafern verwendet werden.

7.  Verfahren nach Anspruch 1,
    **dadurch gekennzeichnet,**
    **dass** die Silicium schmelze mittels in den ersten Feststoffpartikeln vorhandenen Dotierelementen dotiert wird, wobei insbesondere als Dotierelemente Bor, Phosphor, Elemente der III. Gruppe und/oder der V. Gruppe des Periodensystems verwendet werden.

8.  Verfahren nach zumindest Anspruch 7,
    **dadurch gekennzeichnet,**
    **dass** hochdotierte erste Feststoffpartikel der Dotierung $p^+1$, $p^+2$, ..., $p^+n$ der Dotierungskonzentration $p^+_i$ mit $1x10^{17}$ $cm^{-3} \leq p^+_i \leq 1x10^{20}$ $cm^{-3}$, insbesondere mit $p^+_i$ : $1x10^{18}$ $cm^{-3} \leq p^+_i \leq 1x10^{19}$ $cm^{-3}$, in den Mengen $m^+_l$ bis $m^+_n$ zusammen mit zweiten weniger dotierten Feststoffpartikeln der Konzentrationen $p_1$, $p_2$, ..., $p_m$ der Dotierungskonzentration $p_j$ mit $1x10^{13}$ $cm^{-3} \leq p_j \leq 1x10^{17}$ $cm^{-3}$, insbesondere mit $p_j$ : $1x10^{14}$ $cm^{-3} \leq p_j \leq 1x10^{16}$ $cm^{-3}$, in den Mengen $m_l$ bis $m_m$ so vermischt werden, dass sich eine resultierende Dotierung der Schmelze $p_r$ ergibt, wobei die Beziehung gilt:

$$\sum_{i=1}^{n} m^{+}_{i}p^{+}_{i} \quad + \quad \sum_{j=1}^{m} m_{j}p_{j} \quad = p_{r}\left(\sum_{i=1}^{n} m_{i} \quad + \quad \sum_{j=1}^{m} m_{j}\right)$$

**9.** Verfahren nach Anspruch 1,
**dadurch gekennzeichnet,**
**dass** die Feststoffpartikel in einem oder mehreren Abschnitten des zumindest einen Rohres oder Rohrsystems beschleunigt werden.

**10.** Verfahren zur Herstellung von festem Silicium durch Kristallisation des Silicium aus einer Siliciumschmelze, wobei entsprechend aus der in einem Behältnis vorhandenen Siliciumschmelze gezogenes kristallisiertes Silicium der Siliciumschmelze aus Silicium bestehendes oder dieses enthaltendes Feststoffmaterial zugeführt wird,
**dadurch gekennzeichnet,**
**dass** das Feststoffmaterial aus ersten und zweiten Feststoffpartikeln besteht oder diese zumindest enthält, dass die ersten Feststoffpartikel aus gebrochenem Siliciummaterial bestehen und die zweiten Feststoffpartikel eine sphärische oder ellipsoide Geometrie aufweisen und dass das Feststoffmaterial mittels eines Fluids gefördert wird.

**11.** Verfahren nach Anspruch 10,
**dadurch gekennzeichnet,**
**dass** das Feststoffmaterial durch ein Rohr gefördert wird, das die Schmelze mittig durchsetzt oder von dieser konzentrisch umgeben ist, dass die Feststoffpartikel über ein oberhalb des Rohres angeordnetes eine Kegelgeometrie aufweisendes Umlenkelement in Richtung des Behälters umgelenkt werden und dass die Feststoffpartikel über ein das Rohr umgebendes außenrandseitig im Bereich der Schmelze verlaufendes eine Kugeloberflächenabschnittgeometrie aufweisendes Abweiselement in die Schmelze geleitet werden.

**12.** Verfahren nach Anspruch 1 oder 10,
**dadurch gekennzeichnet,**
**dass** als Fluid ein Gas bestehend aus Pressluft, Stickstoff, Argon und/oder Kohlendioxid oder eine Mischung dieser verwendet wird.

**13.** Verfahren nach Anspruch 10,
**dadurch gekennzeichnet,**
**dass** Siliziumscheiben nach dem Edge-Defined Film-fed Growth-Bandziehverfahren hergestellt werden.

**14.** Verfahren nach Anspruch 11,
**dadurch gekennzeichnet,**
**dass** das die Kegelgeometrie aufweisende Umlenkelement und das Abweiselement in ihrer Geometrie auf die Morphologie und das Mischungsverhältnis der Feststoffpartikel abgestimmt sind.

**15.** Verfahren nach Anspruch 11,
**dadurch gekennzeichnet,**
**dass** die Temperatur des Abweiselements und/oder des Umlenkelements im Bereich von 300 °C bis 1200 °C, bevorzugt zwischen 1000 °C und 1120 °C eingestellt wird.

**16.** Verfahren nach Anspruch 11,
**dadurch gekennzeichnet,**
**dass** das die Kegelgeometrie aufweisende Umlenkelement einen Öffnungswinkel $\alpha$ mit vorzugsweise $30° \leq \alpha \leq 60°$, insbesondere $\alpha$ in etwa 45°, und an seiner Basis einen Durchmesser d und das Abweiselement an seiner Basis einen Durchmesser D mit $0,2 \leq d/D \leq 0,8$ aufweisen.

**Claims**

**1.** A process for conveying silicon solid particles of irregular geometry to a silicon melt from which solid silicon is produced by crystallization, where for conveying said silicon solid particles having an irregular geometry such as broken silicon material and being first solid particles second solid particles with spherical or ellipsoid geometry are added, said conveying is performed by means of a fluid through at least one pipe or pipe system having a curve or several curves and/or a kink or several kinks.

2. Process according to claim 1,
   **characterized in**
   **that** proportion of the first solid particles is approximately 1% to about 50% of total quantity of the first and second solid particles.

3. Process according to claim 1,
   **characterized in**
   **that** the solid particles are conveyed by means of fluid packages, whereat especially the fluid is supplied to the pipe or pipe system in pulses at regular or irregular intervals.

4. Process according to claim 1,
   **characterized in**
   **that** the first solid particles have an elongated form with a width B and a length L in a length-to-width ratio of L:B of about $\leq 3$.

5. Process according to claim 4,
   **characterized in**
   **that** the maximum length L of the first solid particles is the radius of the pipe.

6. Process according to claim 1,
   **characterized in**
   **that** fragments of CVD polysilicon rods, fragments of multicrystalline blocks, fragments and/or end pieces of silicon single crystals, and fragments of monocrystalline or multicrystalline wafers are used as broken silicon material.

7. Process according to claim 1,
   **characterized in**
   **that** the silicon melt is doped using doping elements present in the first solid particles, whereat boron and phosphorus, elements of the $\text{III}^{\text{rd}}$ group and/or of $\text{V}^{\text{th}}$ group of the periodic table are used as doping elements.

8. Process according to claim 7,
   **characterized in**
   **that** highly doped first solid particles of the doping $p^+_1$, $p^+_2$, ..., $p^+_n$ of the doping concentration $p^+_i$ with $1\times10^{17}$ cm$^{-3} \leq p^+_i \leq 1\times10^{20}$ cm$^{-3}$, in particular with $p^+_i$ : $1\times10^{18}$ cm$^{-3} \leq p^+_i \leq 1\times10^{19}$ cm$^{-3}$, in the quantities $m^+_1$ to $m^+_n$ are mixed together with second less doped solid particles of the concentrations $p_1$, $p_2$ ...,$p_m$ of the doping concentration $p_j$ with $1\times10^{13}$cm$^{-3} \leq p_j \leq 1\times10^{17}$cm$^{-3}$, in particular with $p_j$ : $1\times10^{14}$ cm$^{-3} \leq p_j \leq 1\times10^{16}$ cm$^{-3}$, in the quantities $m_l$ to $m_m$ such that a resultant doping of the melt $p_r$ is obtained, where the following equation applies:

$$\sum_{i=1}^{n} m^+_i p^+_i \quad + \quad \sum_{j=1}^{m} m_j p_j \quad = p_r \left( \sum_{i=1}^{n} m_i + \sum_{j=1}^{m} m_j \right) \quad .$$

9. Process according to claim 1,
   **characterized in**
   **that** the solid particles are accelerated in one or more sections of the at least one pipe or pipe system.

10. Process for manufacturing solid silicon by crystallization of the silicon from a silicon melt, where crystalline silicon grown from the silicon melt present in a container is supplied appropriately to the silicon melt comprising or containing solid material,
    **characterized in**
    **that** the solid material consists of or contains at least first and second solid particles, that the first solid particles consists of broken silicon material and the second solid particles have a spherical or ellipsoid geometry and that the solid material is conveyed by a fluid.

**11.** Process according to claim 10,
**characterized in**
**that** the solid material is conveyed through a pipe passing through the center of the melt or being concentrically surrounded thereby, that the solid particles are deflected in the direction of the container by a deflecting element arranged above the pipe and having a conical geometry, and that the solid particles are passed into the melt by a baffle element surrounding the pipe, passing round the outer edge in the area of the melt and having a spherical surface section geometry.

**12.** Process according to claim 1 or 10,
**characterized in**
**that** a gas consisting of compressed air, nitrogen, argon and/or carbon dioxide or a mixture thereof is used as the fluid.

**13.** Process according to claim 10,
**characterized in**
**that** silicon wafers are manufactured using the Edge-Defined Film-Fed Growth process.

**14.** Process according to claim 11,
**characterized in**
**that** the deflecting element having the conical geometry and the baffle element are adapted in their geometry to the morphology and to the mixing ratio of the solid particles.

**15.** Process according to claim 11,
**characterized in**
**that** the temperature of the baffle element and/or the deflecting element is set in the range between 300° C and 1200° C, preferably between 1000° C and 1120° C.

**16.** Process according to claim 11,
**characterized in**
the deflecting element having the conical geometry has an opening angle $\alpha$ of preferably $30° \le \alpha \le 60°$, in particular $\alpha$ around 45°, and at its base a diameter d and the baffle element at its base a diameter D with $0.2 \le d/D \le 0.8$.

**Revendications**

**1.** Procédé pour transporter des particules solides de silicium de géométrie irrégulière vers un silicium en fusion à partir duquel du silicium solide est fabriqué par cristallisation, sachant qu'aux particules solides de silicium de géométrie irrégulière tel que du matériau en silicium cassé servant de premières particules solides sont ajoutées, pour le transport au moyen d'un fluide à travers au moins un tuyau ou un système de tuyaux présentant une courbe ou plusieurs courbes et/ou un coude ou plusieurs coudes, des secondes particules solides composées de silicium ou en contenant, et présentant une géométrie régulière, telle qu'une géométrie sphérique ou ellipsoïde.

**2.** Procédé selon la revendication 1,
**caractérisé en ce**
**que** la proportion de premières particules solides est comprise entre environ 1 % et environ 50 % de la quantité totale de particules solides premières et secondes.

**3.** Procédé selon la revendication 1,
**caractérisé en ce**
**que** les particules solides sont transportées au moyen d'ensembles fluides, sachant en particulier que le fluide est introduit par pulsation à intervalles réguliers ou irréguliers dans le tuyau ou système de tuyaux.

**4.** Procédé selon la revendication 1,
**caractérisé en ce**
**que** les premières particules solides présentent une forme oblongue d'une largeur B et d'une longueur L avec un rapport longueur-largeur de L : B d'environ $\le 3$.

**5.** Procédé selon la revendication 4,
**caractérisé en ce**

**que** la longueur L des premières particules solides est au maximum le rayon du tuyau.

6. Procédé selon la revendication 1,
**caractérisé en ce**
des fragments de barres de polysilicium CVD, des fragments de blocs mulicristallins, des fragments ou des extrémités de silicium monocristallin, des fragments de plaquettes de silicium mono- et/ou mulicristallin sont utilisés en tant que matériau en silicium cassé.

7. Procédé selon la revendication 1,
**caractérisé en ce**
**que** le silicium en fusion est dopé au moyen d'éléments dopants disponibles dans les premières particules solides, sachant que du bor, du phosphore, des éléments du 3ème et/ou du 4ème groupe de la classification périodique sont en particulier utilisés comme éléments dopants.

8. Procédé selon la revendication 7,
**caractérisé en ce**
**que** les premières particules solides hautement dopées du dopage $p^+_1$, $p^+_2$, ..., $p^+_n$ de la concentration dopante $p^+_i$ de $1\times10^{17}$ cm$^{-3}$ $\leq p^+_i \leq 1\times10^{20}$ cm$^{-3}$, en particulier de $p^+_i$ : $1\times10^{18}$ cm$^{-3}$ $\leq p^+_i \leq 1\times10^{19}$ cm$^{-3}$, dans les quantités $m^+_l$ à $m^+_n$, sont mélangées aux secondes particules solides moins dopées des concentrations $p_1$, $p_2$, ..., $p_m$ de la concentration dopante $p_j$ de $1\times10^{13}$ cm$^{-3}$ $\leq p_j \leq 1\times10^{17}$ cm$^{-3}$, en particulier de $p_j$ de $1\times10^{14}$ cm$^{-3}$ $\leq p_j \leq 1\times10^{16}$ cm$^{-3}$, dans les quantités $m_l$ à $m_m$, de telle manière qu'il en résulte un dopage de la masse en fusion $p_r$, où s'applique la relation :

$$\sum_{i=1}^{n} m^+_i p^+_i \quad + \quad \sum_{j=1}^{m} m_j p_j \quad = p_r \left( \sum_{i=1}^{n} m_i + \sum_{j=1}^{m} m_j \right)$$

9. Procédé selon la revendication 1,
**caractérisé en ce**
**que** les particules solides sont accélérées dans une ou plusieurs sections du tuyau ou système de tuyaux au moins en présence.

10. Procédé de fabrication de silicium solide par cristallisation du silicium à partir de silicium en fusion, sachant qu'en fonction du silicium cristallisé retiré du silicium en fusion disponible dans un récipient, du matériau solide composé de silicium ou en contenant est ajouté au silicium en fusion,
**caractérisé en ce**
**que** le matériau solide est composé de premières et secondes particules solides, ou au moins en contient, que les premières particules solides sont composées de matériau en silicium cassé et les secondes particules solides présentent une géométrie sphérique ou ellipsoïde, et que le matériau solide est transporté au moyen d'un fluide.

11. Procédé selon la revendication 10,
**caractérisé en ce**
**que** le matériau solide est transporté par un tuyau qui traverse la masse en fusion en son milieu ou qui est entouré par celle-ci de manière concentrique, que les particules solides sont déviées en direction du récipient par un élément directionnel disposé au-dessus du tuyau et présentant une géométrie conique, et que les particules solides sont conduites dans la masse en fusion par l'intermédiaire d'un élément déviateur s'étendant autour du tuyau du côté du bord extérieur dans la zone de la masse en fusion et présentant en section la géométrie d'une surface sphérique.

12. Procédé selon la revendication 1 ou 10,
**caractérisé en ce**
**qu'**un gaz composé d'air comprimé, d'azote, d'argon et/ou de dioxyde de carbone ou d'un mélange de ceux-ci est utilisé en tant que fluide.

13. Procédé selon la revendication 10,
**caractérisé en ce**

**que** des plaquettes de silicium sont fabriquées selon le procédé de croissance Edge Defined Film Fed Growth.

**14.** Procédé selon la revendication 11,
**caractérisé en ce**
**que** la géométrie de l'élément directionnel présentant une géométrie conique et de l'élément déviateur est adaptée à la morphologie et au rapport de mélange des particules solides.

**15.** Procédé selon la revendication 11,
**caractérisé en ce**
**que** la température de l'élément déviateur et/ou de l'élément directionnel est réglée dans la plage de 300 °C à 1200 °C, de préférence entre 1000 °C et 1120 °C.

**16.** Procédé selon la revendication 11,
**caractérisé en ce**
**que** l'élément directionnel présentant la géométrie conique présente un angle d'ouverture $\alpha$ de préférence de 30° $\leq \alpha \leq$ 60°, en particulier $\alpha$ d'environ 45°, et à sa base un diamètre d et l'élément déviateur à sa base un diamètre D de 0,2 $\leq$ d/D $\leq$ 0,8.

Fig.1

Fig. 2

EP 1 726 034 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4016894 A
- US 5683503 A
- EP 1245703 A
- GB 1406650 A
- WO 8701362 A
- WO 9014450 A
- WO 9105723 A
- WO 8606764 A
- US 5242531 A
- US 6090199 A